Europäisches Patentamt

European Patent Office

Office européen des brevets

(11) Veröffentlichungsnummer: **0 368 030 B1**

(12) **EUROPÄISCHE PATENTSCHRIFT**

(45) Veröffentlichungstag der Patentschrift: **01.06.94**

(51) Int. Cl.⁵: **G01R  31/00**

(21) Anmeldenummer: **89119128.0**

(22) Anmeldetag: **14.10.89**

(54) **Messverfahren und Schaltungsanordnung zur Ermittlung des Auslösestroms von FI-Schaltern.**

(30) Priorität: **20.10.88 DE 3835677**

(43) Veröffentlichungstag der Anmeldung:
**16.05.90 Patentblatt  90/20**

(45) Bekanntmachung des Hinweises auf die
Patenterteilung:
**01.06.94 Patentblatt  94/22**

(84) Benannte Vertragsstaaten:
**AT CH DE FR GB IT LI NL**

(56) Entgegenhaltungen:
**DE-A- 3 421 829**
**DE-A- 3 421 873**
**DE-B- 2 658 185**

(73) Patentinhaber: **Gossen- Metrawatt GmbH**
**Thomas-Mann-Strasse 20**
**D-8500 Nürnberg(DE)**

(72) Erfinder: **Ziegler, Herbert**
**Hartensteiner Strasse 66**
**D-8500 Nürnberg(DE)**
Erfinder: **Clever, Carl W.**
**Wittelsbacher Strasse 79a**
**D-8500 Nürnberg 50(DE)**
Erfinder: **Kindermann, Robert**
**Brettergartenstrasse 9**
**D-8500 Nürnberg(DE)**

(74) Vertreter: **Hafner, Dieter, Dr.rer.nat.,**
**Dipl.-Phys. et al**
**Dr. Hafner & Stippl,**
**Patentanwälte,**
**Ostendstrasse 132**
**D-90482 Nürnberg (DE)**

## Beschreibung

Die Erfindung betrifft ein Meßverfahren der im Oberbegriff des Anspruchs 1 genannten Art sowie eine Schaltungsanordnung zur Durchführung dieses Verfahrens.

Das Ausschaltverhalten eines Fehlerstrom-Schutzschalters wird durch seine Auslösezeit und seinen Auslösestrom bestimmt. Beide Größen ermittelt man mit Hilfe eines Prüfstroms, der zur Ermittlung der Auslösezeit seinen eingestellten Wert beibehält, während er zur Ermittlung des Auslösestroms stetig oder in Stufen ansteigen muß. Für die Beurteilung des jeweiligen Netzes, in dem der FI-Schalter für ausreichende Sicherheit sorgen soll, ist es weiterhin von Interesse, wie hoch die Berührungsspannung ist, die beim Auslösen des FI-Schalters am Schutzleiter anliegt.

Bekannte Meßverfahren, die eine Ermittlung sowohl des Auslösestroms als auch der beim Auslösen anliegenden Berührungsspannung ermöglichen, arbeiten mit getrennten Meßeinheiten, die jede für sich eine der beiden Meßgrößen ermittelt. Hierdurch wird nicht nur die Meßapparatur relativ aufwendig, sondern auch der Meßablauf ist nicht einfach, da zwei unterschiedliche Größen zur gleichen Zeit gemessen werden müssen.

Aus DE-B-26 58 185 ist eine Schaltungsanordnung zur Erzeugung eines Prüfstromes zwecks Prüfung von Schutzschaltern bekanntgeworden, bei welcher beim Überschreiten eines ermittelten Grenzwertes der Berührungsspannung (Spannung zwischen Schutzleiter und Erde) während des automatischen Anstieges des Prüfstromes über eine elektronische Verstärkeranordnung der Prüfstromfluß unterbrochen wird.

Aus EP-A-0 165 512 (=DE-A-3 421 873) ist schließlich ein Meßverfahren zur Ermittlung der Differenz zwischen zwei Spannungen durch einen zeitgesteuerten Meßablauf, der dafür sorgt, daß in aufeinanderfolgenden fest vorgegebenen Zeitspannen zuerst die eine und dann die andere Spannung integriert wird, bekannt.

Aus DE-A-3 421 829 geht außerdem ein Meßverfahren hervor, bei welchem die bei Fehlernennstrom des jeweiligen FI-Schalters auftretende Berührungsspannung nur einmal ermittelt wird.

Aufgabe der Erfindung ist es, ein Meßverfahren der im Oberbegriff des Anspruchs 1 genannten Art zu schaffen, das es ermöglicht, auf einfache Weise neben dem Auslösestrom auch die Berührungsspannung zu messen, wobei die hierzu erforderliche Schaltungsanordung mit einem zweipoligen Anschluß auskommen soll.

Diese Aufgabe wird durch die in den Ansprüchen 1 und 13 gekennzeichneten Merkmale gelöst. Zweckmäßige Ausgestaltungen und Weiterbildungen der Erfindung sind in den Unteransprüchen genannt.

Das erfindungsgemäße Meßverfahren kommt bei einem Prüfgerät zur Anwendung, das nicht nur zur Überprüfung von FI-Schaltern dient, sondern mit dem man auch die Berührungsspannung, den Netzinnenwiderstand, den Schleifwiderstand und den Erdungswiderstand eines zu überprüfenden Wechselspannungsnetzes messen kann. Das Gerät bedarf somit keiner zusätzlichen Ausrüstung, um zu Beginn des Meßablaufs die Berührungsspannung zu ermitteln. Zu beachten ist, daß die Berührungsspannung nicht bei Fehlernennstrom gemessen werden darf, da andernfalls der Strom zu einem Auslösen des FI-Schalters führen würde, bevor seine eigentliche Prüfung beginnt. Es hat sich als zweckmäßig erwiesen, die Berührungsspannung bei einem Drittel des Fehlernennstroms zu messen und die gesuchte auf den Fehlernennstrom bezogene Berührungsspannung entsprechend hochzurechnen.

Sobald die auf den Fehlernennstrom bezogene Berührungsspannung gespeichert ist, kann die eigentliche Prüfung des FI-Schalters mit Hilfe eines in Stufen ansteigenden Konstantstroms beginnen. Hat der Konstantstrom eine Höhe erreicht, bei der der FI-Schalter auslöst, so ergibt sich der Auslösestrom unmittelbar aus dem Stufenwert des Konstantstroms. Da der Stufenendwert des Konstantstroms dem Fehlernennstrom entspricht und die auf den Fehlernennstrom bezogene Berührungsspannung bekannt ist, kann auch die im Auslösezeitpunkt auftretende Berührungsspannung vom Rechner des Meßgerätes ermittelt und zur Anzeige ausgegeben werden.

In einer zweckmäßigen Ausgestaltung der Erfindung ist vorgesehen, den Konstantstrom von einem Basiswert von 0,3 des Nennfehlerstroms bis zum Nennfehlerstrom ansteigen zu lassen. Man kann davon ausgehen, daß der Auslösestrom des FI-Schalters im Normalfall in diesem Bereich liegen wird.

Eine ausreichende Genauigkeit der Messung wird erzielt, wenn man den Konstantstrom in Stufen von 1 % des Nennfehlerstroms ansteigen läßt. Eine Stufenlänge von 40 ms reicht im allgemeinen aus, damit der FI-Schalter den Strom als Konstantstrom empfindet und die Dynamik der Stufen nicht in Erscheinung tritt.

In einer zweckmäßigen Weiterbildung des erfindungsgemäßen Verfahrens wird die Berührungsspannung nach der Methode der Spannungsabsenkung gemessen. Diese Methode ist in der EP-A-0 165 512 (=DE-A-34 21 873) in Verbindung mit einer Auf-Ab-Integration beschrieben. Die Messung erstreckt sich über mehrere Perioden, wobei jeweils auf eine Leerlaufperiode eine Lastperiode folgt, bei der das Netz mit einem Prüfstrom belastet wird. Die Differenz zwischen der gemessenen Leerlaufspannung und der Lastspannung entspricht der zu ermittelnden Berührungsspannung, sofern zwischen dem L- und dem PE-Leiter des Netzes gemessen wird. Bei dem vorbekannten Verfahren wird die Differenzspannung auf besonders einfache Weise dadurch erfaßt, daß zwei gleichgerichtete Halbwellen der Leerlaufspannung aufintegriert und bei Last zwei folgende gleichgerichtete Halbwellen abintegriert werden. Die im Integrator verbleibende Restspannung entspricht dabei der gesuchten Differenzspannung, die die Berührungsspannung repräsentiert.

Um eine von Spannungsschwankungen weitgehend unbeeinflußte, möglichst genaue Messung zu ermöglichen, wird der aus einer Auf-Ab-Integration bestehende Integrationszyklus mehrfach wiederholt, so daß sich die Messung insgesamt über eine Vielzahl von Perioden erstreckt. Der während dieser Zeit über den Schutzleiter PE fließende Prüfstrom kann in fehlerhaften Netzen zu unzulässigen Berührungsspannungen führen.

Die von zu hohen Berührungsspannungen ausgehende Gefahr ist um so geringer, je kürzer die Spannung am Schutzleiter anliegt. Nach VDE ist diese Zeit auf max. 200 ms zu begrenzen, während die KEMA empfiehlt eine Zeit von 40 ms nicht zu überschreiten.

Eine wesentliche Weiterbildung des erfindungsgemäßen Verfahrens wird deshalb darin gesehen, den Verfahrensablauf so zu gestalten, daß beim Auftreten gefährlicher Berührungsspannungen diese nicht über einen Zeitraum von 40 ms hinaus am Schutzleiter anstehen können. Hierzu wird die nach jedem Integrationszyklus ermittelte Ausgangsspannung mit einem Limitwert verglichen, der dem Grenzwert der noch zulässigen Berührungsspannung entspricht. Eine Unterbrechung des Konstantstroms erfolgt, sobald die Ausgangsspannung größer als der Limitwert ist. Parallel zu der sich über mehrere Integrationszyklen erstreckenden Hauptmessung erfolgt also nach jedem Integrationszyklus eine Testmessung, die bei einer überhöhten Berührungsspannung innerhalb von 40 ms ein Abschalten des Prüfstroms bewirkt. Da die Ausgangsspannung am Integrator nach jedem Integrationszyklus ansteigt, muß auch der Limitwert entsprechend erhöht werden.

Eine besonders einfache Methode zur Abschaltung des Konstantstroms besteht darin, diesen bei jeder Halbwelle neu einzuschalten und den hierfür erforderlichen Einschaltimpuls zur Bewirkung der Abschaltung zu unterdrücken.

Eine zweckmäßige Weiterbildung der Erfindung sieht weiterhin vor, in Verbindung mit der Hauptmessung zur Überprufüng von FI-Schaltern zunächst eine Pilotmessung durchzuführen, bei der die Netzspannung im Leerlauf erfaßt wird. Dieser Spannungswert wird gespeichert und dient als Referenzwert für sich anschließende Spannungsmessungen unter Belastung mit einem vorgegebenen Konstantstrom. Letztere dienen als Testmessungen, die jeweils in der ersten Halbwelle einer Periode durchgeführt und in der zweiten Halbwelle ausgewertet werden. Auch hier kann also bei überhöhter Berührungsspannung bereits nach einer Periode ein Abschaltbefehl gegeben werden. Die jeweilige Berührungsspannung ergibt sich aus der Differenz zwischen dem gespeicherten Referenzwert und dem jeweiligen momentanen Testwert.

Für die Durchführung der Messung ist wichtig, daß der Konstantstrom programmierbar ist und damit in seinem Wert automatisch geändert werden kann. So werden je nach Art der Hauptmessung unterschiedliche Konstantströme benötigt. Bei den Hauptmessungen nach der Spannungsabsenkungsmethode wird der Konstantstrom vorzugsweise auf 30 % des Nennfehlerstroms im Netz liegender FI-Schalter programmiert, damit die Messung durchgeführt werden kann, ohne daß der FI-Schalter abschaltet.

Eine zu hohe Berührungsspannung wird gegebenenfalls vorgetäuscht, wenn z.B. der FI-Schalter im Laufe der Messung abgeschaltet hat aber zum Zeitpunkt der Pilotmessung noch eingeschaltet war, so daß die Differenzspannung dem Wert der Referenzspannung entspricht. Um diesen Fall auszuschließen, wird vor der Meldung einer gefährlichen Berührungsspannung noch das Anliegen der Netzspannung geprüft.

Weiterhin ist es möglich, daß der FI-Schalter bei seiner Überprufung mit dem Nennfehlerstrom nicht innerhalb der vorgeschriebenen Zeit abgeschaltet hat. Eine Fehlermeldung erfolgt jedoch erst dann, wenn feststeht, daß in der letzten Periode des Prüfablaufs der Konstantstrom noch fließt. Nach Ablauf der automatischen Messung wird nämlich auch ohne daß der FI-Schalter den Stromkreis unterbricht der Konstantstrom abgeschaltet.

Für die vorgesehene Sicherheitsabschaltung durch Unterbrechung des Konstantstroms ist der Lastzweig von besonderer Bedeutung. Er beinhaltet zwei in Reihe liegende Glieder, die beide ein Abschalten des Konstantstroms ermöglichen. So wird, wie bereits erläutert, bei zu hoher Berührungsspannung der Einschaltimpuls, der die nächste Halbwelle des Konstantstroms auslöst, unterdrückt, so daß die Konstantstromschaltung keinen Strom mehr abgibt. Gleichzeitig wird jedoch auch das Relais betätigt das den Stromkreis noch während der anstehenden Halbwelle unterbricht. Das Relais wirkt somit schneller und besitzt auch ein höheres Abschaltvermögen. Mit Hilfe der Stromüberwachung läßt sich eine Unterbrechung des Stromkreises auf einfache Weise verifizieren.

Ein Ausführungsbeispiel der Erfindung ist in den Zeichnungen dargestellt und wird im folgenden näher beschrieben.

Es zeigen:

Figur 1: Eine Schaltungsanordnung zur Durchführung des erfindungsgemäßen Verfahrens,

Figur 2: Strom- und Spannungsdiagramme über mehrere Perioden des Meßablaufs bei einer Messung nach der Spannungsabsenkungsmethode,

Figur 3: Strom- und Spannungsdiagramme über mehrere Perioden eines Meßablaufs zur Prüfung des Ausschaltverhaltens eines FI-Schalters,

Figur 4: Verlauf des stufig ansteigenden Konstantstroms zur Ermittlung des Auslösestroms und der zugehörigen Berührungsspannung.

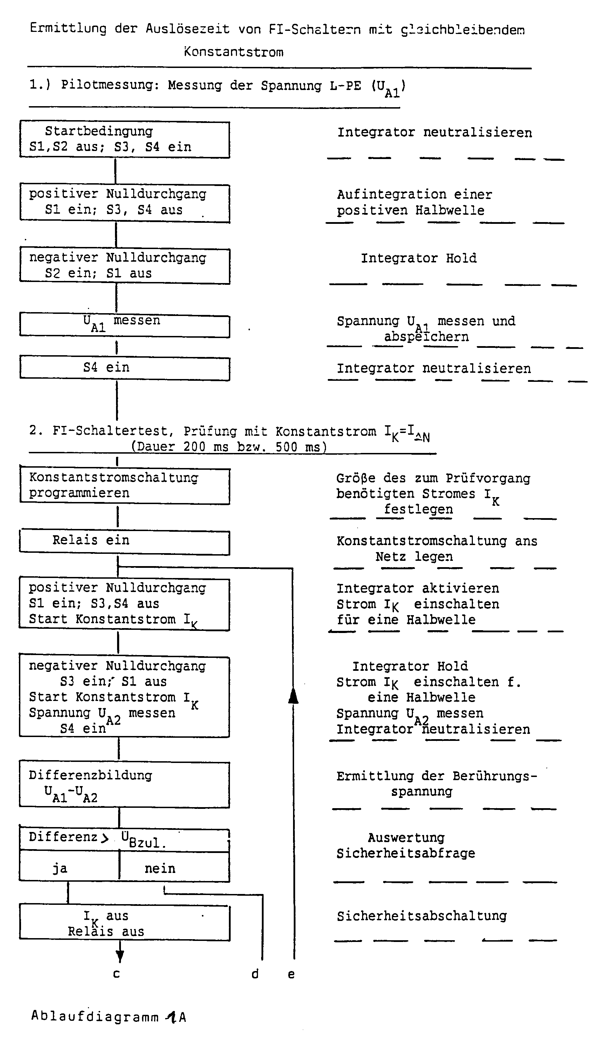

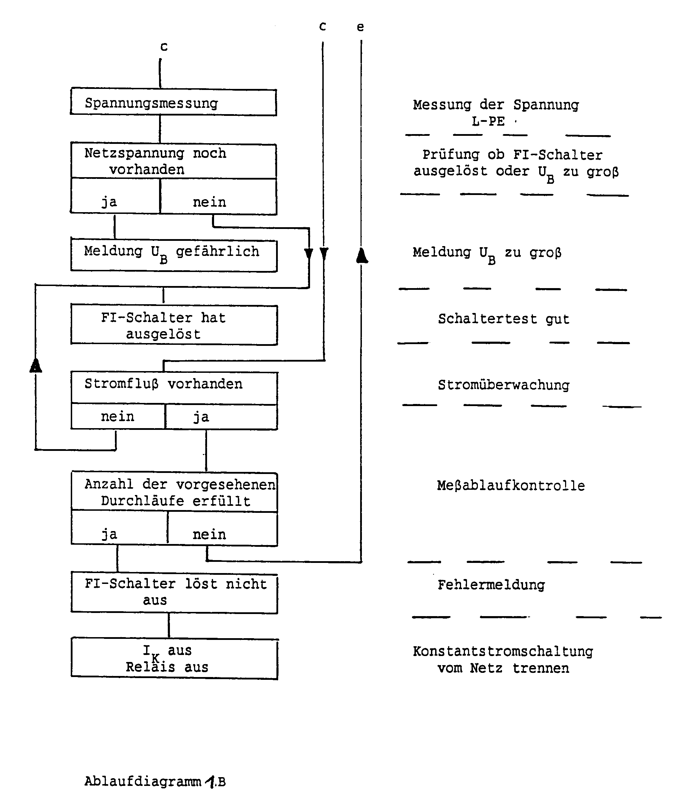

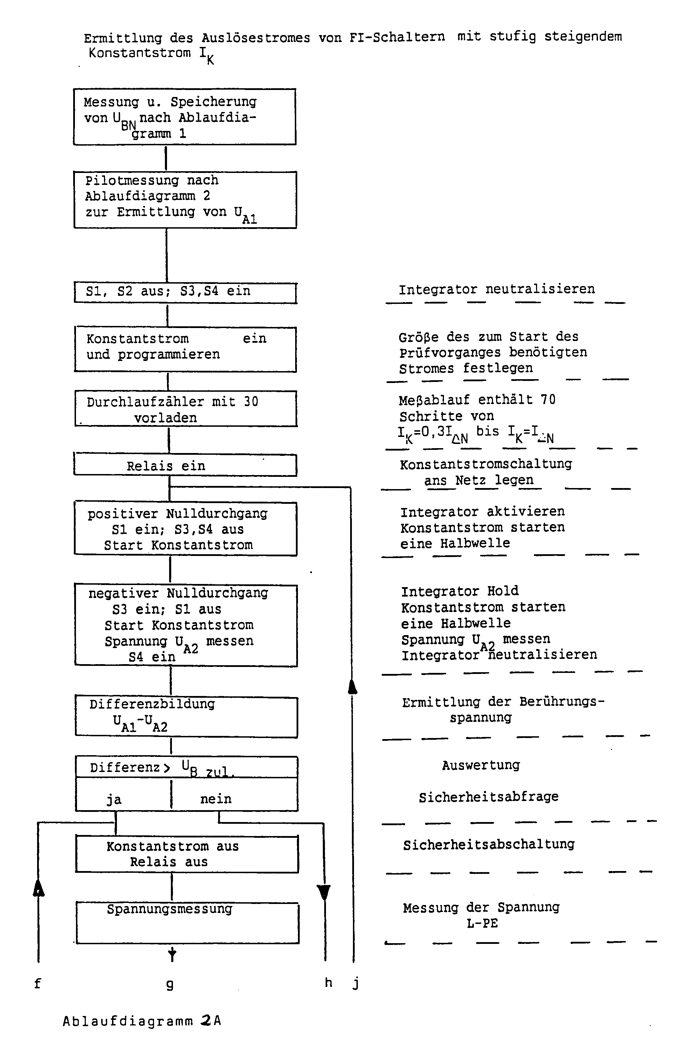

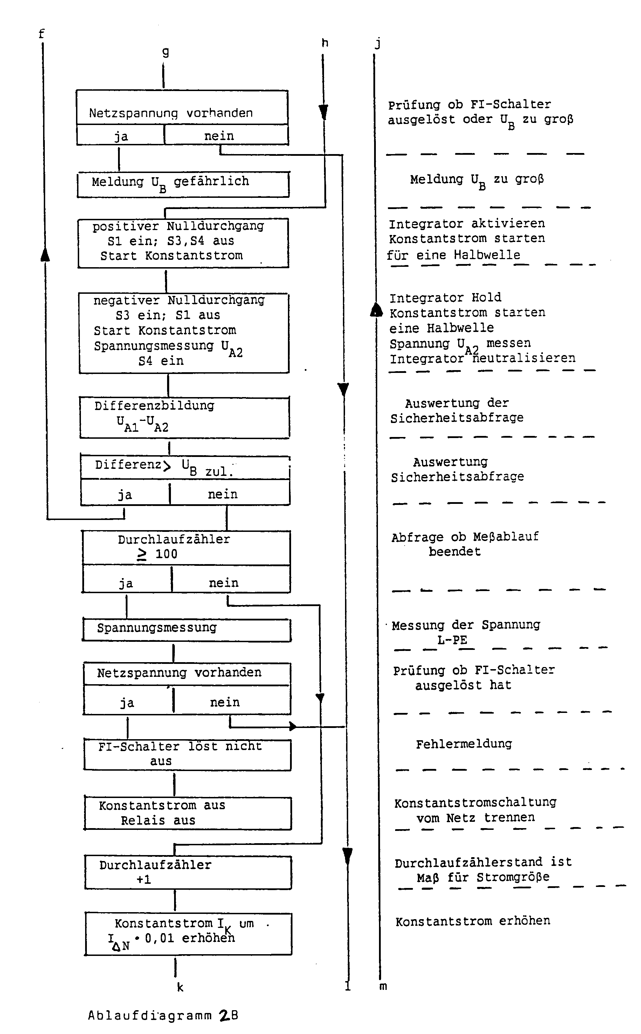

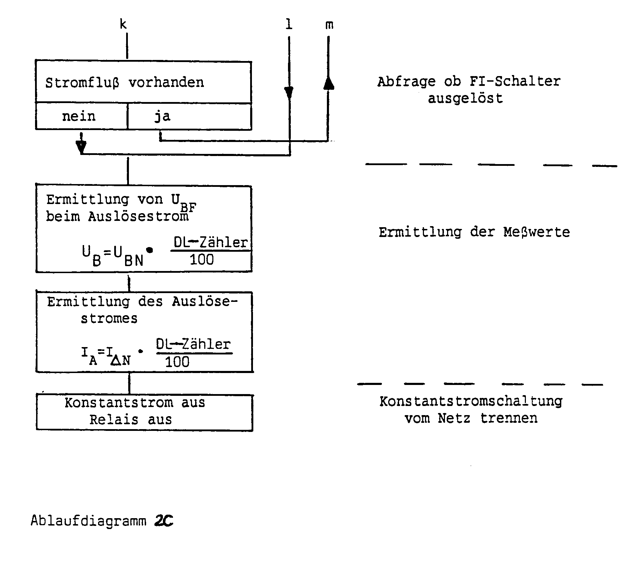

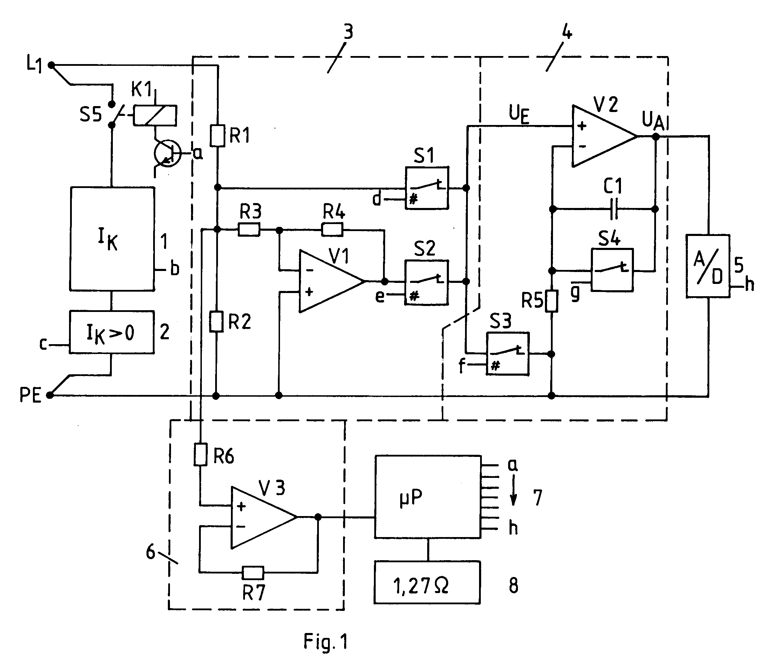

Die in Figur 1 dargestellte Schaltungsanordnung dient zur Durchführung verschiedener Meßverfahren, wobei unterschiedliche Meßgrößen ermittelt werden, die eine Überprüfung von Schutzmaßnahmen in Wechselstromnetzen ermöglichen. Die Schaltung enthält einen gesteuerten Zweiweggleichrichter 3, der mit seinem Eingang zwischen Phase L1 und dem Schutzleiter PE eines zu überprüfenden Wechselspannungsnetzes angeschlossen ist. Je nach Art der durchzuführenden Messung könnte der zweipolige Eingang auch zwischen Phase und Null-Leiter angeschlossen sein. Am Ausgang des gesteuerten Zweiweggleichrichters 3 liegt ein gesteuerter Integrator 4, dem ein A/D-Wandler 5 nachgeschaltet ist. Einem Mikroprozessor 7 wird das Ausgangssignal des A/D-Wandlers 5 sowie eines Null-Detektors 6 zugeführt. Der Null-Detektor 6 liegt mit seinem Eingang an einem Spannungsteiler R1, R2, der die Netzanschlüsse L1, PE miteinander verbindet und gleichzeitig auch den Eingang des gesteuerten Zweiweggleichrichters 3 bildet.

Die vom Spannungsteiler R1, R2 herabgesetzte Netzspannung wird von seinem Abgriff einem ersten gesteuerten Schalter S1 zugeführt, der am Eingang des Integrators 4 liegt. Einem zweiten ebenfalls mit dem Eingang des Integrators 4 verbundenen gesteuerten Schalter S2 ist ein invertierender Verstärker V1,R3,R4 vorgeschaltet, dessen Eingang an dem Abgriff des Spannungsteilers R1, R2 liegt.

Zu dem gesteuerten Integrator 4 gehören ein Verstärker V2, der eingangsseitig von einem dritten gesteuerten Schalter S3 überbrückt ist, und in dessen Gegenkopplungszweig ein Ladekondensator C1 liegt, dem ein vierter gesteuerter Schalter S4 parallel geschaltet ist.

Am Eingang der Schaltungsanordnung zwischen Phase L1 und Schutzleiter PE ist ein Lastzweig angeschlossen, der aus der Reihenschaltung eines Relaisschalters S5, einer Konstantstromschaltung 1 und einer Stromüberwachung 2 besteht. Der Relaisschalter S5 wird über ein Relais K1 betätigt, das seinerseits über den an einem vorgeschalteten Transistor liegenden Steueranschluß a vom Rechner 7 gesteuert wird. Weitere Steueranschlüsse b bis h sind ebenfalls mit dem Rechner verbunden, der über den A/D-Wandler 5 die jeweiligen Meßwerte abfragt und nach ihrer Auswertung das Meßergebnis auf einem Display 8 zur Anzeige bringt.

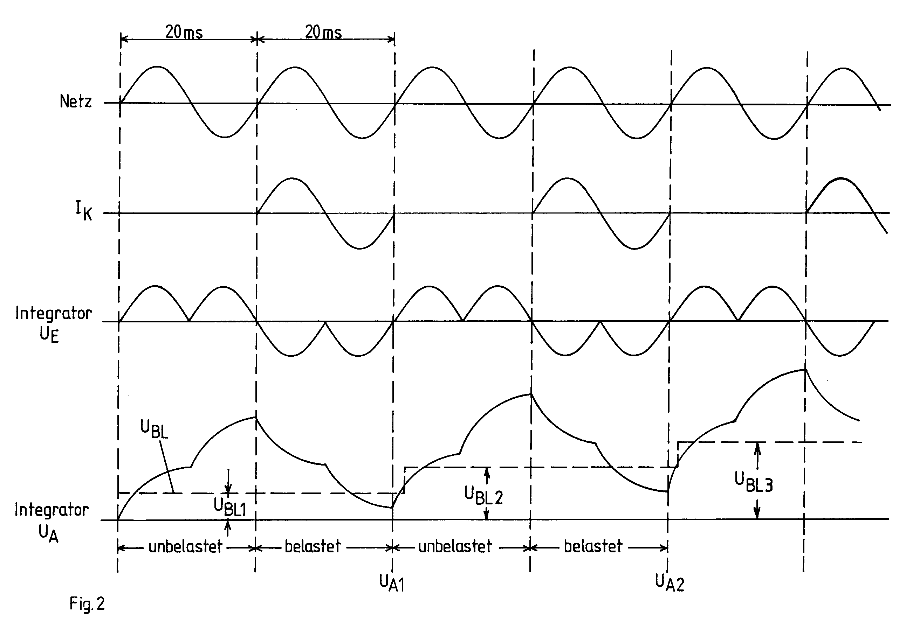

Die in Figur 2 dargestellten Diagramme sollen einen Meßablauf verdeutlichen, wie er bei der Messung der Berührungsspannung, des Netzinnenwiderstandes, des Schleifenwiderstandes und des Erdungswiderstandes zur Anwendung kommt. Bei der Ermittlung dieser Meßgrößen wird nach der Methode der Spannungsabsenkung verfahren. Das bedeutet, daß auf eine Leerlaufphase eine Lastphase folgen muß, so daß die Netzspannung sowohl im Leerlauf als auch unter Last gemessen werden kann. Der Differenzwert dieser beiden Spannungen ist der gesuchten Meßgröße proportional. Im vorliegenden Fall ist die Dauer der Last- und der Leerlaufphase auf jeweils eine Periode festgelegt. Der die Last bildende Konstantstrom $I_K$ wird somit nach einer Periode jeweils für die Dauer einer weiteren Periode unterbrochen. Es wird mit einem Konstantstrom $I_K$ gearbeitet, um Lastschwankungen, die das Meßergebnis verfälschen könnten, zu vermeiden.

Das Diagramm der am Eingang des Integrators 4 anliegenden Eingangsspannung $U_E$ verdeutlicht die Wirkungsweise des gesteuerten Zweiweggleichrichters 3. Der invertierende Verstärker V1, R3,R4 sorgt dafür, daß die am gesteuerten Schalter S2 anliegende Netzwechselspannung um 180° gegenüber der am gesteuerten Schalter S1 anliegenden Spannung in der Phase verschoben wird. Die beiden gesteuerten Schalter S1,S2 werden nun so geschaltet, daß sie eine Gleichrichtung bewirken aber derart, daß sich die Polarität der gleichgerichteten Wechselspannung nach jeweils einer Periode umkehrt. Somit folgen jeweils auf zwei positive Halbwellen zwei negative Halbwellen. Die negativen Halbwellen entsprechen der Lastphase und besitzen dementsprechend eine etwas geringere Amplitude als die im Leerlauf gemessenen positiven Halbwellen.

Das Diagramm der Ausgangsspannung $U_A$ am Ausgang des Integrators 4 läßt dessen Wirkungsweise erkennen. Die beiden positiven Halbwellen der Eingangsspannung $U_E$ werden zunächst aufintegriert und anschließend mit den beiden negativen Halbwellen abintegriert. Da die Amplitude der negativen Halbwelle durch die Belastung geringer ist, verbleibt am Integratorausgang eine Restspannung $U_A$, die der Differenz zwischen Last- und Leerlaufspannung entspricht.

Um die verbleibende Restspannung zu erhöhen und damit die Meßgenauigkeit zu verbessern, folgen jeweils mehrere Integrationszyklen aufeinander, wobei jeder Integrationszyklus sich über zwei Perioden erstreckt. Die nach dem letzten Integrationszyklus am Ausgang des Integrators 4 verbleibende Ausgangsspannung wird mit Hilfe des Rechners durch die Zahl der Integrationszyklen geteilt und ergibt danach einen Mittelwert, in dem Schwankungen einzelner Perioden weitgehend eliminiert sind.

Der in der Lastphase fließende Konstantstrom $I_K$ könntebei fehlerhaftem Netz zu einer gefährlichen Berührungsspannung führen. Eine genaue Messung der Berührungsspannung über mehrere Integrationszyklen erfordert eine weit längere Zeit als 40 ms. Damit im Gefahrenfall bei zu hoher Berührungsspannung der Konstantstrom $I_K$ sofortabgeschaltet werden kann, wird nach jedem Integrationszyklus eine Testmessung vorgenommen, bei der die während der Hauptmessung ermittelte Ausgangsspannung $U_A$ mit einem vorgegebenen Limitwert $U_{BL}$ verglichen wird. Der Limitwert $U_{BL}$ entspricht der oberen Grenze, der noch zulässigen Berührungsspannung $U_B$ und muß nach jedem Integrationszyklus erhöht werden. Da die Ausgangsspannung am Integrator $U_{A2}$ etwa den doppelten Wert von $U_{A1}$ erreicht, muß auch $U_{BL2}$ auf den doppelten und $U_{BL3}$ auf den dreifachen Wert von $U_{BL1}$ festgelegt werden.

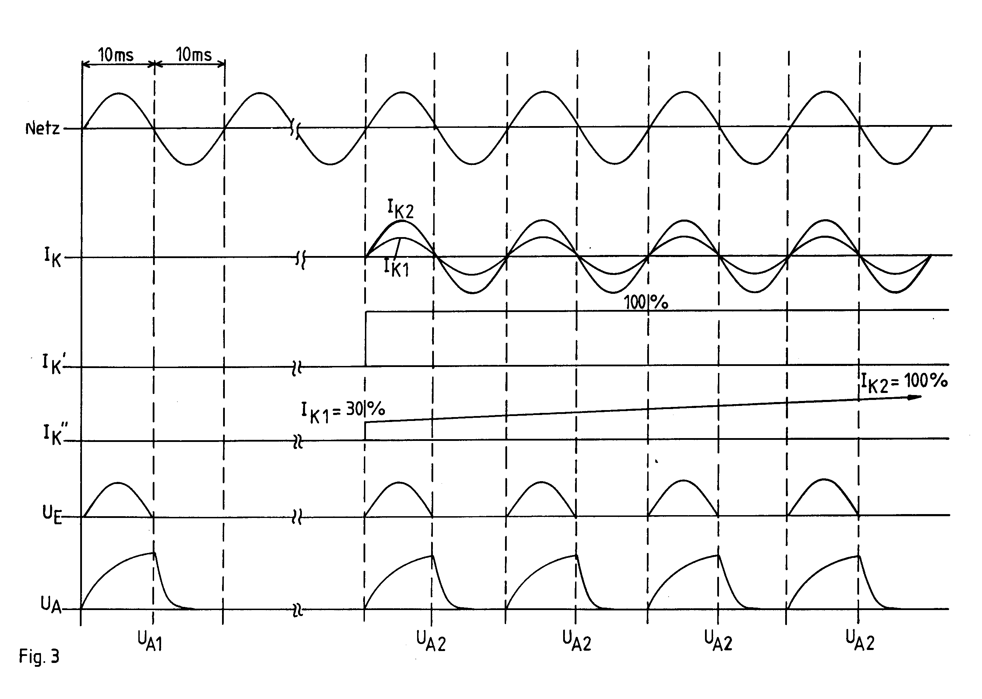

Die in Figur 3 dargestellten Diagramme sollen den Meßablauf bei der Überprüfung eines FI-Schalters verdeutlichen. Sein Schaltverhalten wird wiederum mit einem Konstantstrom $I_K$ untersucht. Zur Ermittlung der Auslösezeit wird ein mit $I_K$, gekennzeichneter Konstantstrom vorgegeben, der nach dem Einschalten auf den vollen Wert des Nennfehlerstroms des jeweilen FI-Schalters springt. Die Amplitude des Konstanstroms könnte einen Wert $I_{K2}$ erreichen, der bis zum Ansprechen des FI-Schalters konstant gehalten und erst nach Abschluß der Messung abgeschaltet wird.

Den Wert des Stroms, bei dem der FI-Schalter abschaltet, kann man ermitteln, indem man die Amplitude des Konstantstroms von einem niedrigen Wert $I_{K1}$ stetig oder stufig erhöht. Wie durch die Kurve $I_{K''}$ angedeutet ist, erreicht der Konstantstrom nach dem Einschalten einen Basiswert von 30 % des Fehlernennstroms und steigt dann bis 100 % an. Die Konstantstromschaltung 1 ist so programmiert, daß der Konstantstrom in Stufen von 1 % ansteigt, so daß sich unmittelbar aus dem beim Abschalten erreichten Stufenwert der Abschaltstrom des FI-Schalters ergibt.

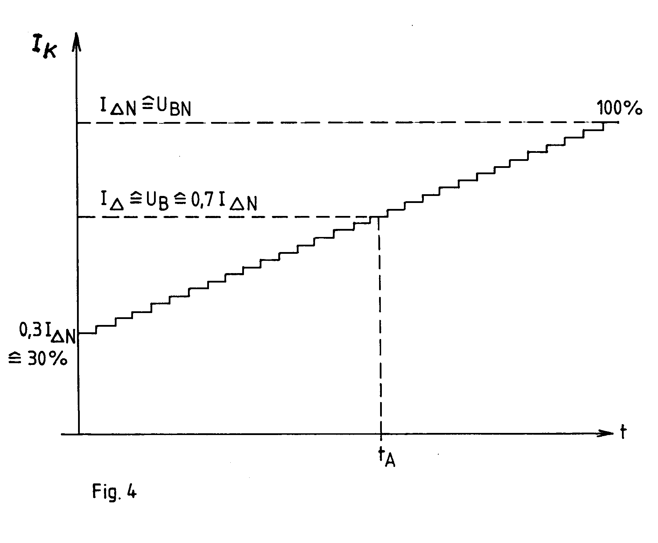

In Figur 4 ist der stufig ansteigende Konstantstrom $I_K$ noch einmal im Detail dargestellt. Die gezeichneten Stufen kennzeichnen die steigende Wechselspannungsamplitude des Konstantstroms. Die höchste Stufe von 100 % entspricht dem Fehlernennstrom $I_{\Delta N}$ sowie der hierauf bezogenen Berührungsspannung $U_{BN}$. Wenn nun, wie in diesem Beispiel angenommen, der FI-Schalter zum Zeitpunkt $t_A$ auslöst, kann über den Stufenwert von $I_K$ der Auslösestrom $I_\Delta$ und auch die zu diesem Zeitpunkt anliegende Berührungsspannung $U_B$ festgestellt werden. Der Stufenwert von $I_K$ wird mittels eines Durchlaufzählers während des programmierten Stufenanstiegs erfaßt. Im vorliegenden Beispiel liegt er bei 70 %.

Der für die Messung nach Figur 2 ohnehin erforderliche Integrator 4 wird für die vorstehend erläuterte Messung nach Figur 3 nicht benötigt, so daß er für die zur Berührungsspannungsmessung erforderlichen Testmessungen herangezogen werden kann. Wie das Diagramm in Figur 3 erkennen läßt, werden die gesteuerten Schalter S1,S2 so geschaltet, daß jeweils nur die positive Halbwelle $U_E$ an den Eingang des Integrators 4 gelangt. Diese Spannung wird während der ersten halben Periode aufintegriert und nach Übernahme des Ausgangsspannungswertes durch den Rechner 7 in der sich anschließenden halben Periode durch Neutralisieren des Integrators mit Hilfe der gesteuerten Schalter S3,S4, gelöscht.

Die aus Sicherheitsgründen durchzuführende grobe Bestimmung der Berührungsspannung erfolgt derart, daß zunächst bei Leerlauf eine Pilotmessung durchgeführt wird und die hierbei ermittelte Ausgangsspannung $U_{A1}$ gespeichert wird. Nach Einschalten des Konstantstroms $I_K$ erfolgt eine erneute Messung der Ausgangsspannung, wobei ein Wert $U_{A2}$ ermittelt wird. Diese Messung wird in jeder Periode wiederholt. Die Differenz der beiden Spannungen $U_{A1}$ und $U_{A2}$ entspricht der jeweiligen Berührungsspannung. Überschreitet die Berührungsspannung den zulässigen Wert, so werden die Konstantstromschaltung 1 und auch der Relaisschalter S5 abgeschaltet.

Ein wesentlicher Vorteil der Erfindung ist, daß alle Messungen mit der gleichen Schaltungsanordnung durchgeführt werden können, so daß bezüglich der erforderlichen Hardware kein Zusatzaufwand entsteht.

Die wichtigsten Schritte der vorstehend in ihrem Grundprinzip erläuterten Meßverfahren sind in zwei Ablaufdiagrammen registriert. So zeigt das aus den Teilen 1A und 1B bestehende Ablaufdiagramm 1 die Ermittlung der Auslösezeit von FI-Schaltern, die mit Hilfe eines gleichbleibenden Konstantstroms $I_K$ erfolgt. Hier wird der eigentlichen Messung die schon erläuterte Pilotmessung zur Ermittlung der Leerlaufspannung des Netzes vorangestellt.

Das Ablaufdiagramm 2 erläutert mit seinen Teilen 2, 2B und 2C das zur Ermittlung des Auslösestroms von FI-Schaltern angewandte Verfahren, bei dem mit einem stufig steigenden Konstantstrom $I_K$ gearbeitet wird. Es umfaßt somit den eigentlichen an Hand der Figur 4 bereits erläuterten Kern der Erfindung. Damit die im Auslösezeitpunkt $t_A$ auftretende Berührungsspannung ermittelt werden kann, muß vor dem Auslösen des FI-Schalters die auf den Nennfehlerstrom $I_{\Delta N}$ bezogene Berührungsspannung $U_{BN}$ gemessen werden. Diese Messung erfolgt entsprechend dem Ablaufdiagramm 1.

Im Rahmen der Testmessungen, die bei erhöhter Berührungsspannung ein Abschalten des Konstantstroms $I_K$ bewirken sollen, muß dem eigentlichen Meßablauf weiterhin eine Pilotmessung vorangestellt werden, wie sie bereits aus dem Ablaufdiagram 1 bekannt ist. Erst jetzt kann die Konstantstromschaltung für den Anstieg von $I_K$ programmiert und der Durchlaufzähler entsprechend eingestellt werden.

**Patentansprüche**

1. Meßverfahren zur Ermittlung des Auslösestroms ($I_\Delta$) von FI-Schaltern in Wechselstromnetzen mit Hilfe eines ansteigenden Prüfstromes und zur Ermittlung der Berührungsspannung ($U_B$) beim Auslösen des FI-Schalters,
   **gekennzeichnet durch**
   **den zeitlichen Ablauf folgender Verfahrensschritte:**
   a) zunächst wird die bei Fehlernennstrom ($I_{\Delta N}$) des jeweiligen FI-Schalters auftretende Berührungsspannung ($U_B$) bei einem Konstantstrom ($I_K$) ermittelt, der kleiner als der mögliche Auslösestrom ($I_\Delta$) des FI-Schalters ist, wobei die Ermittlung mehrfach durchgeführt wird und der ermittelte Wert nach jedem Meßvorgang mit einem Limitwert verglichen wird, der den Grenzwert der noch zulässigen Berührungsspannung ($U_B$) repräsentiert;
   b) die ermittelte auf Fehlernennstrom ($I_{\Delta N}$) bezogene Berührungsspannung ($U_{BN}$) wird gespeichert;
   c) nach Speicherung gemäß Schritt b) wird der ansteigende Prüfstrom durch einen stetig, in vorgegebenen Zeitabständen um einen vorgegebenen Wert ansteigenden Konstantstrom realisiert;
   d) der zum Zeitpunkt der Auslösung des FI-Schalters dem Auslösestrom ($I_\Delta$) entsprechende Konstantstrom ($I_K$) wird zur Anzeige gebracht;
   e) die beim Auslösestrom ($I_\Delta$) auftretende Berühungsspannung ($U_B$) wird aus der Beziehung $U_B = U_{BN} I_\Delta / I_{\Delta N}$ errechnet und zur Anzeige gebracht sowie
   f) eine Abschaltung des Konstantstroms ($I_K$) erfolgt innerhalb von 40 msec nach jeder Berührungsspannungsspeicherung, bei der sich eine Überhöhung der Berührungsspannung gegenüber dem Limitwert ($U_{BL}$) ergibt.

2. Meßverfahren nach Anspruch 1, dadurch gekennzeichnet, daß der Konstantstrom ($I_K$) von einem Basiswert von 0,3 des Nennfehlerstrom ($I_{\Delta N}$) bis zum Nennfehlerstrom ansteigt.

3. Meßverfahren nach Anspruch 1, dadurch gekennzeichnet, daß die Stufen des ansteigenden Konstantstroms ($I_K$) einer Wechselstromamplitude von 0,01 des Nennfehlerstroms $I_{\Delta N}$ entsprechen und im zeitlichen Abstand von 40ms aufeinander folgen.

4. Meßverfahren nach einem der vorhergehenden Ansprüche, dadurch gekennzeichnet, daß die Ermittlung der Berührungsspannung nach dem Spannungsabsenkungsverfahren erfolgt, wobei die gleichgerichtete Netzspannung über eine Periode im Leerlauf aufintegriert und über eine sich anschließende Periode bei einer durch einen Konstantstrom ($I_K$) vorgegebenen Last abintegriert wird und die nach Abschluß dieses Integrationszyklusses am Ausgang des Integrators (4) verbleibende Ausgangsspannung ($U_A$) der Berührungsspannung proportional ist.

5. Meßverfahren nach einem der vorhergehenden Ansprüche, dadurch gekennzeichnet, daß die Ausgangsspannung ($U_A$) am Integrator (4) mit einem Limitwert ($U_{BL}$) verglichen wird, der den Grenzwert der noch zulässigen Berührungsspannung ($U_B$) repräsentiert und eine Unterbrechung des Konstantstromes ($I_K$) erfolgt, wenn die Ausgangsspannung ($U_A$) größer als der Limitwert ($U_{BL}$) ist.

6. Meßverfahren nach einem der vorhergehenden Ansprüche, dadurch gekennzeichnet, daß ein erster Limitwert ($U_{BL1}$) der in Verbindung mit einer ersten Ausgangsspannung ($U_{A1}$) im ersten Integrationszyklus vorgegeben wird, im zweiten Integrationszyklus mit einer zweiten Ausgangsspannung ($U_{A2}$) auf einen zweiten Limitwert ($U_{BL2}$) verdoppelt und im dritten Integrationszyklus verdreifacht wird, so daß nach n Integrationszyklen der Limitwert $U_{BLn} = n \cdot U_{BL1}$ erreicht wird.

7. Meßverfahren nach einem der vorhergehenden Ansprüche, dadurch gekennzeichnet, daß der Konstantstrom ($I_K$) bei Erreichen des Nulldurchgangs jeweils für die Dauer einer Halbwelle erneut eingeschaltet wird und eine Unterbrechung des Konstantstroms ($I_K$) durch Unterdrückung des Einschaltimpulses erfolgt.

8. Meßverfahren nach einem der vorhergehenden Ansprüche, dadurch gekennzeichnet, daß bei der Überprüfung des Ausschaltverhaltens von FI-Schaltern eine Pilotmessung zur Erfassung der Netzspannung im Leerlauf durchgeführt wird und die hierzu über eine Halbwelle integrierte Leerlaufspannung ($U_{A1}$) gespeichert wird und daß der Pilotmessung weitere Messungen der Netzspannung, nunmehr während einer Belastung mit einem Konstantstrom ($I_K$) folgen, wobei die Netzspannung wiederum über je eine Halbwelle integriert und die in der jeweiligen Halbwelle gemessene Lastspannung ($U_{A2}$) mit der gespeicherten Leerlaufspannung ($U_{A1}$) verglichen wird.

9. Meßverfahren nach einem der vorhergehenden Ansprüche, dadurch gekennzeichnet, daß der Wert des Konstantstroms ($I_K$) programmierbar ist und der Konstantstrom mit jeder Halbwelle so oft erneut eingeschaltet wird, bis dies durch eine Sicherheitsunterbrechung oder nach Abschluß der FI-Schalterprüfung unterbunden wird und die Sicherheitsunterbrechung erfolgt, sobald die Differenzspannung zwischen der Leerlaufspannung ($U_{A1}$) und der Lastspannung ($U_{A2}$) den noch zulässigen Wert der Berührungsspannung ($U_B$) überschreitet.

10. Meßverfahren nach einem der vorhergehenden Ansprüche, dadurch gekennzeichnet, daß auf eine erste Halbwelle des Konstantstroms ($I_K$) während der die Integration zur Ermittlung der Lastspannung ($U_{A2}$) abläuft sich eine Auswertungsphase zur Ermittlung der Differenzspannung und ihrer Bewertung bezüglich der zulässigen Berührungsspannung ($U_B$) anschließt und während der sich über eine Halbwelle erstreckenden Auswertungsphase jeweils eine Neutralisation der Integrator-Ausgangsspannung ($U_A$) erfolgt.

11. Meßverfahren nach einem der vorhergehenden Ansprüche, dadurch gekennzeichnet, daß im Fall des Überschreitens der zulässigen Berührungsspannung ($U_B$) durch die ermittelte Differenzspannung ($U_{A1}-U_{A2}$) der somit gefährliche Wert erst gemeldet wird, wenn eine Prüfung ergeben hat, daß die Netzspannung noch anliegt.

12. Meßverfahren nach einem der vorhergehenden Ansprüche, dadurch gekennzeichnet, daß zur Klärung, ob der FI-Schalter nach erfolgter Überprüfung mit dem vorgegebenen Konstantstrom ($I_K$) innerhalb der vorgeschriebenen Zeit nicht ausgeschaltet hat und somit eine Fehlermeldung zu erfolgen hat, zuvor festgestellt wird, ob noch ein Konstantstrom ($I_K$) fließt.

13. Schaltungsanordnung zur Ermittlung des Auslösestroms von FI-Schaltern in Wechselstromnetzen mit einer Vorrichtung zur Ermittlung einer Berührungsspannung und einer Einrichtung zur Erzeugung eines als steuerbare Last wirkenden Konstantstroms ($I_K$),
**dadurch gekennzeichnet,**
daß an zwei Netzspannungsanschlüssen (L1, PE) ein gesteuerter Zweiweggleichrichter (3) liegt, der eine gleichgerichtete Wechselspannung ($U_E$) dem Eingang eines Integrators (4) zuführt, dessen Ausgangsspannung ($U_A$) an einem A/D-Wandler (5) angeschlossen ist und weiterhin ein Rechner (7) das Ausgangssignal des A/D-Wandlers (5) verarbeitet und in Abhängigkeit hiervon und vom Ausgangssignal eines Nulldetektors (6) den Integrator (4), den Zweiweggleichrichter (3) und einen Lastzweig (S5, 1, 2) netzsynchron steuert, wobei eine Vorrichtung zur mindestens einmaligen Wiederholung der Durchführung des Integrations- und Auswertvorgangs betreffend das Ausgangssignal des A/D-Wandlers durch den Rechner (7) vorgesehen ist und der an den beiden Netzanschlüssen (L1, PE) anliegende Lastzweig (S5, 1, 2) aus einer Reihenschaltung eines vom Rechner (7) über ein Relais (K1) gesteuerten Schalters (S5), einer programmierbaren Konstantstromschaltung (1) und einer Stromüberwachung (2) besteht.

14. Schaltungsanordnung nach Ansprüch 13, dadurch gekennzeichnet, daß der Zweiweggleichrichter (3) zwei mit seinem Ausgang verbundene steuerbare Schalter (S1,S2) besitzt, von denen der erste Schalter (S1) unmittelbar am Abgriff eines an den Netzanschlüssen (L1,PE) angeschlossenen Spannungsteilers (R1,R2) anliegt während der zweite Schalter (S2) über einen invertierenden Verstärker (V1,R3,R4) am Abgriff angeschlossen ist.

15. Schaltungsanordnung nach einem der Ansprüche 13 und 14, dadurch gekennzeichnet, daß der Integrator (4) einen dritten und einen vierten steuerbaren Schalter (S3,S4) besitzt, von denen der dritte Schalter (S3) seinen Eingang gegen Bezugspotential (PE) kurzschließen kann und der vierte Schalter (S4) seinen Ladekondensator (C1) überbrückt.

**Claims**

1. Measuring method for determining the trip current ($I_\Delta$) of residual-current breakers in AC networks with the aid of an increasing test current and for determining the contact voltage ($U_B$) when the residual-current breaker is tripped, characterised by the following sequence of steps:

a) firstly the contact voltage ($U_B$) which occurs with the nominal residual current ($I_{\Delta N}$) of the respective residual-current breaker is determined with a constant current ($I_K$) which is smaller than the possible trip current ($I_\Delta$) of the residual-current breaker, the determination being carried out repeatedly and the value determined after each measurement being compared with a limit value which represents the limit value of the permissible contact voltage ($U_B$);

b) the contact voltage ($U_{BN}$) determined with reference to the nominal residual current ($I_N$) is stored;

c) after storage according to step b), the increasing test current is produced by a constant current which increases steadily by a predetermined value at predetermined time intervals;

d) the constant current ($I_K$) at the time when the residual-current breaker is tripped, which corresponds to the trip current ($I_\Delta$), is displayed;

e) the contact voltage ($U_B$) which occurs with the trip current ($I_\Delta$) is calculated from the relationship $U_B = U_{BN} I_\Delta/I_{\Delta N}$ and displayed; and

f) the constant current ($I_K$) is switched off within 40 msec after each storage of the contact voltage when there is an excessive increase in the contact voltage relative to the limit value ($U_{BL}$).

2. Measuring method according to Claim 1, characterised in that the constant current ($I_K$) increases from a base value of 0.3 of the nominal residual current ($I_{\Delta N}$) up to the nominal residual current.

3. Measuring method according to Claim 1, characterised in that the steps of the increasing constant current ($I_K$) correspond to an AC amplitude of 0.01 of the nominal residual current ($I_{\Delta N}$) and follow each other at time intervals of 40 ms.

4. Measuring method according to any one of the preceding claims, characterised in that the determination of the contact voltage takes place according to the voltage-drop method, wherein the rectified network voltage is integrated upwards over a period in open circuit and is integrated downwards over a subsequent period with a predetermined load given by a constant current ($I_K$), and the output voltage remaining at the output of the integrator (4) after the end of this integration cycle is proportional to the contact voltage.

5. Measuring method according to any one of the preceding claims, characterised in that the output voltage ($U_A$) in the integrator (4) is compared with a limit value ($U_{BL}$) which represents the limit value of the permissible contact voltage ($U_B$) and the contact current ($I_K$) is interrupted if the output voltage ($U_A$) is greater than the limit value ($U_{BL}$).

6. Measuring method according to any one of the preceding claims, characterised in that a first limit value ($U_{BL1}$) which is given in connection with a first output voltage ($U_{A1}$) in the first integration cycle is doubled to a second limit value ($U_{BL2}$) in the second integration cycle with a second output voltage ($U_{A2}$) and is trebled in the third integration cycle, so that, after n integration cycles, the limit value $U_{BLn} = n \cdot U_{BL1}$ is reached.

7. Measuring method according to any one of the preceding claims, characterised in that each time zero crossing is reached, the constant current ($I_K$) is switched on again for the duration of one half wave and an interruption of the constant current ($I_K$) takes place by the suppression of the switching pulses.

8. Measuring method according to any one of the preceding claims, characterised in that, in a test of the switching-off behaviour of residual-current breakers, a pilot measurement is carried out to acquire the network voltage in open circuit and the open-circuit voltage ($U_{A1}$) integrated for this over one half wave is stored, and in that the pilot measurement is followed by further measurements of the network voltage during loading, from this point on, with a constant current ($I_K$), the network voltage being integrated again over each half wave and the load voltage ($U_{A2}$) measured in each half wave being compared with the open-circuit voltage ($U_{A1}$) stored.

9. Measuring method according to any one of the preceding claims, characterised in that the value of the constant current ($I_K$) is programmable and the constant current is switched on again with each half wave until it is stopped by a safety interruption or after the end of the test of a residual-current breaker, and the safety interruption takes place as soon as the voltage difference between the open-circuit voltage

($U_{A1}$) and the load voltage ($U_{A2}$) exceeds the permissible value of the contact voltage ($U_B$).

10. Measuring method according to any one of the preceding claims, characterised in that a first half wave of the constant current ($I_K$), during which the integration to determine the load voltage ($U_{A2}$) takes place, is followed by an evaluation phase for determining the voltage difference and evaluating it in relation to the permissible contact voltage ($U_B$) and the integrator output voltage ($U_A$) is neutralised during each evaluation phase, which lasts for one half wave.

11. Measuring method according to any one of the preceding claims, characterised in that, in the event of the permissible contact voltage ($U_B$) being exceeded by the voltage difference ($U_{A1}$ - $U_{A2}$) determined, the value, which is consequently dangerous, is indicated only when a test has revealed that the network voltage is still connected.

12. Measuring method according to any one of the preceding claims, characterised in that, in order to clarify whether the residual-current breaker has not switched off within the prescribed time after a test has been carried out with the predetermined constant current ($I_K$) and a fault indication should thus result, it is first determined whether a constant current ($I_K$) is still flowing.

13. Circuit for determining the trip current of residual-current breakers in AC networks, with a device for determining a contact voltage and a device for supplying a constant current ($I_K$) as a controllable load, characterised in that a controlled full-wave rectifier is connected to two network voltage connections (L1, PE) and supplies a rectified alternating voltage ($U_E$) to the input of an integrator (4), the output voltage ($U_A$) of which is connected to an A/D convertor (5) and, moreover, a computer (7) processes the output signal of the A/D convertor (5) and, in dependence thereon and on the output signal of a zero detector (6), controls the integrator (4), the full-wave rectifier (3), and a load branch (S5, 1, 2) synchronised with the network, a device being provided for repeating at least once the integration and evaluation in relation to the output signal of the A/D convertor carried out by the computer (7) and the load branch (S5, 1, 2) connected to the two network connections (L1, PE) consisting of a switch (S5) controlled by the computer (7) by means of a relay (K1), a programmable constant current circuit (1) and a current monitor (2) connected in series.

14. Circuit according to Claim 13, characterised in that the full-wave rectifier (3) comprises two controllable switches (S1, S2) which are connected to its input and of which the first switch (S1) is connected directly to the tap of a voltage divider (R1, R2) connected to the network connections (L1, PE) whilst the second switch (S2) is connected to the tap by means of an inverting amplifier (V1, R3, R4).

15. Circuit according to any one of Claims 13 and 14, characterised in that the integrator (4) comprises third and fourth controllable switches (S3, S4), the input of the third switch (S3) being able to be short-circuited to a reference potential (PE) and the fourth switch (S4) bypassing its charging capacitor (C1).

**Revendications**

1. Procédé de mesure pour la détermination du courant de déclenchement ($I_\Delta$) de disjoncteurs à courant de défaut dans des réseaux à courant alternatif, à l'aide d'un courant d'essai croissant, et pour la détermination de la tension de contact ($U_B$) lors du déclenchement du disjoncteur à courant de défaut,
   caractérisé par le déroulement chronologique des étapes suivantes :
   a) la tension de contact ($U_B$), apparaissant pour un courant nominal de défaut ($I_{\Delta N}$) du disjoncteur à courant de défaut concerné, est tout d'abord déterminée pour un courant constant ($I_K$), qui est plus petit que le courant de déclenchement ($I_\Delta$) possible du disjoncteur à courant de défaut, la détermination étant effectuée de manière répétée et la valeur déterminée après chaque opération de mesure est comparée à une valeur limite, qui représente la valeur limite de la tension de contact ($U_B$) encore admissible ;
   b) la tension de contact ($U_{BN}$), détectée et rapportée au courant nominal de défaut ($I_{\Delta N}$) est mémorisée ;
   c) après mémorisation selon l'étape b), le courant d'essai croissant est obtenu par un courant constant croissant de manière régulière d'une valeur prédéterminée dans des intervalles de temps prédéterminés ;
   d) le courant constant ($I_K$) correspondant au courant de déclenchement ($I_\Delta$), au moment du déclenchement du disjoncteur à courant de défaut, est affiché ;
   e) la tension de contact ($U_B$), apparaissant lors du courant de déclenchement ($I_\Delta$) est

calculée à partir de la relation $U_B = U_{BN}$ $I_\Delta/I_{\Delta N}$, et elle est affichée, et

f) une coupure du courant constant ($I_K$) a lieu dans les 40 msec suivant chaque mémorisation de tension de contact, lors de laquelle se produit une augmentation excessive de la tension de contact par rapport à la valeur limite ($U_{BL}$).

2. Procédé de mesure selon la revendication 1, caractérisé en ce que le courant constant ($I_K$) croît depuis une valeur de base représentant 0,3 du courant nominal de défaut ($I_{\Delta N}$) jusqu'au courant nominal de défaut.

3. Procédé de mesure selon la revendication 1, caractérisé en ce que les gradins du courant constant croissant ($I_K$) correspondent à une amplitude de courant alternatif représentant 0,01 du courant nominal de défaut $I_{\Delta N}$ et se succèdent avec un intervalle de 40 ms.

4. Procédé de mesure selon l'une des revendications précédentes, caractérisé en ce que la détermination de la tension de contact est effectuée d'après le procédé de diminution de tension, la tension de réseau redressée étant intégrée pendant une période en marche à vide et étant neutralisée pendant une période suivante lors d'une charge prédéterminée par un courant constant ($I_K$), et en ce que la tension de sortie ($U_A$) restante, à l'issue de ce cycle d'intégration, à la sortie de l'intégrateur (4) est proportionnelle à la tension de contact.

5. Procédé de mesure selon l'une des revendications précédentes, caractérisé en ce que la tension de sortie ($U_A$) de l'intégrateur (4) est comparée à une valeur limite ($U_{BL}$), qui représente la valeur limite de la tension de contact ($U_B$) encore admissible et en ce qu'il se produit une interruption du courant constant ($I_K$), lorsque la tension de sortie ($U_A$) est supérieure à la valeur limite ($U_{BL}$).

6. Procédé de mesure selon l'une des revendications précédentes, caractérisé en ce qu'une première valeur limite ($U_{BL1}$), qui est prédéterminée en liaison avec une première tension de sortie ($U_{A1}$) dans un premier cycle d'intégration, est doublée dans un deuxième cycle d'intégration avec une deuxième tension de sortie ($U_{A2}$) pour donner une deuxième valeur limite ($U_{BL2}$), et est triplée dans un troisième cycle d'intégration, de telle manière qu'après n cycles d'intégration, on obtient la valeur limite $U_{BLn} = n \cdot U_{BL1}$.

7. Procédé de mesure selon l'une des revendications précédentes, caractérisé en ce que le courant constant ($I_K$) est de nouveau établi, chaque fois pour la durée d'une demi-onde, lors de l'arrivée au passage par zéro, et qu'une interruption du courant constant ($I_K$) se produit par une suppression de l'impulsion de fermeture.

8. Procédé de mesure selon l'une des revendications précédentes, caractérisé en ce que, lors du contrôle du comportement à la coupure de disjoncteurs à courant de défaut, une mesure pilote est effectuée pour détecter la tension du réseau en marche à vide, et la tension à vide ($U_{A1}$) intégrée pendant une demi-onde est mémorisée, et en ce que la mesure pilote est suivie par d'autres mesures de la tension du réseau, désormais pendant une charge avec un courant constant ($I_K$), la tension de réseau étant de nouveau intégrée chaque fois pendant une demi-onde et la tension en charge ($U_{A2}$) mesurée dans la demi-onde concernée est comparée à la tension à vide ($U_{A1}$) mémorisée.

9. Procédé de mesure selon l'une des revendications précédentes, caractérisé en ce que la valeur du courant constant ($I_K$) est programmable et en ce que le courant constant est établi de manière répétée avec chaque demi-onde jusqu'à ce que ceci soit arrêté par une coupure de sécurité ou après la fin du contrôle du disjoncteur à courant de défaut avec pour résultat la coupure de sécurité, dès que la tension différentielle entre la tension à vide ($U_{A1}$) et la tension en charge ($U_{A2}$) dépasse la valeur encore admissible de la tension de contact ($U_B$).

10. Procédé de mesure selon l'une des revendications précédentes, caractérisé en ce que, à une première demi-onde du courant constant ($I_K$), pendant laquelle l'intégration pour la détermination de la tension en charge ($U_{A2}$) se déroule, fait suite une phase d'évaluation pour la détermination de la tension différentielle et de son estimation par rapport à la tension de contact admissible ($U_B$) et pendant la phase d'évaluation s'étendant sur une demi-onde, il se produit chaque fois une neutralisation de la tension de sortie ($U_A$) de l'intégrateur.

11. Procédé de mesure selon l'une des revendications précédentes, caractérisé en ce que, dans le cas d'un dépassement de la tension de contact admissible ($U_B$) par la tension différentielle déterminée ($U_{A1} - U_{A2}$), la valeur par conséquent dangereuse n'est signalée que lorsqu'un contrôle a prouvé que la tension du réseau est encore appliquée.

12. Procédé de mesure selon l'une des revendications précédentes, caractérisé en ce que, pour clarifier le fait que le disjoncteur à courant de défaut n'est pas déconnecté une fois le contrôle terminé avec le courant constant ($I_K$) prédéterminé dans les limites du temps prescrit et donc qu'il doit en résulter un message de défaut, il est d'abord déterminé si un courant constant ($I_K$) passe encore.

13. Disposition de circuit pour la détermination du courant de déclenchement de disjoncteurs à courant de défaut dans des réseaux à courant alternatif, comportant un dispositif pour la détermination d'une tension de contact et un dispositif pour la production d'un courant constant ($I_K$) agissant comme une charge réglable,

caractérisée en ce qu'un redresseur pleine onde (3) commandé est disposé au niveau de deux bornes d'alimentation par le réseau (L1, PE) et qu'il fournit une tension alternative redressée ($U_E$) à l'entrée d'un intégrateur (4), dont la tension de sortie ($U_A$) est reliée à un convertisseur A/N (5) et, en ce que, en outre un ordinateur (7) traite le signal de sortie du convertisseur A/N (5) et, en fonction de cela et du signal de sortie d'un détecteur de passage par zéro (6), commande l'intégrateur (4), le redresseur pleine onde (3) et une branche de charge (S5, 1, 2) de manière synchrone avec le réseau, un dispositif étant prévu pour répéter au moins une fois l'exécution de l'opération d'intégration et d'évaluation concernant le signal de sortie du convertisseur A/N par l'ordinateur (7), et en ce que la branche de charge (S5, 1, 2), adjacente aux deux bornes d'alimentation par le réseau (L1, PE), consiste en un montage en série d'un interrupteur (S5) commandé par l'ordinateur (7) par l'intermédiaire d'un relais (K1), en un montage à courant constant (1) programmable et en un élément de contrôle de courant (2).

14. Disposition de circuit selon la revendication 13, caractérisée en ce que le redresseur pleine onde (3) est muni de deux interrupteurs (S1, S2), agencés de manière à pouvoir être commandés, reliés à sa sortie, le premier interrupteur (S1) étant directement disposé au niveau de la prise d'un diviseur de tension (R1, R2) connecté aux bornes d'alimentation par le réseau (L1, PE) tandis que le deuxième interrupteur (S2) est relié à la prise par l'intermédiaire d'un amplificateur inverseur (V1, R3, R4).

15. Disposition de circuit selon l'une des revendications 13 et 14, caractérisée en ce que l'intégrateur (4) est muni d'un troisième et d'un quatrième interrupteurs (S3, S4) agencés de manière à pouvoir être commandés, le troisième interrupteur (S3) pouvant court-circuiter son entrée par rapport au potentiel de référence (PE) et le quatrième interrupteur (S4) shuntant son condensateur de charge (C1).

Ermittlung der Auslösezeit von FI-Schaltern mit gleichbleibendem Konstantstrom

---

1.) Pilotmessung: Messung der Spannung L-PE ($U_{A1}$)

| | |
|---|---|
| Startbedingung S1,S2 aus; S3, S4 ein | Integrator neutralisieren |
| positiver Nulldurchgang S1 ein; S3, S4 aus | Aufintegration einer positiven Halbwelle |
| negativer Nulldurchgang S2 ein; S1 aus | Integrator Hold |
| $U_{A1}$ messen | Spannung $U_{A1}$ messen und abspeichern |
| S4 ein | Integrator neutralisieren |

2. FI-Schaltertest, Prüfung mit Konstantstrom $I_K = I_{\Delta N}$
(Dauer 200 ms bzw. 500 ms)

| | |
|---|---|
| Konstantstromschaltung programmieren | Größe des zum Prüfvorgang benötigten Stromes $I_K$ festlegen |
| Relais ein | Konstantstromschaltung ans Netz legen |
| positiver Nulldurchgang S1 ein; S3,S4 aus Start Konstantstrom $I_K$ | Integrator aktivieren Strom $I_K$ einschalten für eine Halbwelle |
| negativer Nulldurchgang S3 ein; S1 aus Start Konstantstrom $I_K$ Spannung $U_{A2}$ messen S4 ein | Integrator Hold Strom $I_K$ einschalten f. eine Halbwelle Spannung $U_{A2}$ messen Integrator neutralisieren |
| Differenzbildung $U_{A1} - U_{A2}$ | Ermittlung der Berührungs- spannung |
| Differenz $>$ $U_{Bzul.}$ | Auswertung Sicherheitsabfrage |
| ja | nein | |
| $I_K$ aus Relais aus | Sicherheitsabschaltung |

c       d   e

Ablaufdiagramm 1A

| | |
|---|---|
| Spannungsmessung | Messung der Spannung<br>L-PE · |
| Netzspannung noch<br>vorhanden | Prüfung ob FI-Schalter<br>ausgelöst oder $U_B$ zu groß |
| ja \| nein | |
| Meldung $U_B$ gefährlich | Meldung $U_B$ zu groß |
| FI-Schalter hat<br>ausgelöst | Schaltertest gut |
| Stromfluß vorhanden | Stromüberwachung |
| nein \| ja | |
| Anzahl der vorgesehenen<br>Durchläufe erfüllt | Meßablaufkontrolle |
| ja \| nein | |
| FI-Schalter löst nicht<br>aus | Fehlermeldung |
| $I_K$ aus<br>Relais aus | Konstantstromschaltung<br>vom Netz trennen |

Ablaufdiagramm 1.B

13

EP 0 368 030 B1

Ermittlung des Auslösestromes von FI-Schaltern mit stufig steigendem Konstantstrom $I_K$

Messung u. Speicherung von $U_{BN}$ nach Ablaufdiagramm 1

Pilotmessung nach Ablaufdiagramm 2 zur Ermittlung von $U_{A1}$

S1, S2 aus; S3,S4 ein — Integrator neutralisieren

Konstantstrom ein und programmieren — Größe des zum Start des Prüfvorganges benötigten Stromes festlegen

Durchlaufzähler mit 30 vorladen — Meßablauf enthält 70 Schritte von $I_K=0,3I_{\Delta N}$ bis $I_K=I_{\Delta N}$

Relais ein — Konstantstromschaltung ans Netz legen

positiver Nulldurchgang S1 ein; S3,S4 aus Start Konstantstrom — Integrator aktivieren Konstantstrom starten eine Halbwelle

negativer Nulldurchgang S3 ein; S1 aus Start Konstantstrom Spannung $U_{A2}$ messen S4 ein — Integrator Hold Konstantstrom starten eine Halbwelle Spannung $U_{A2}$ messen Integrator neutralisieren

Differenzbildung $U_{A1}-U_{A2}$ — Ermittlung der Berührungsspannung

Differenz > $U_{B\,zul.}$ — Auswertung
ja | nein — Sicherheitsabfrage

Konstantstrom aus Relais aus — Sicherheitsabschaltung

Spannungsmessung — Messung der Spannung L-PE

f    g    h  j

Ablaufdiagramm 2A

14

f          g                 h    j

| Netzspannung vorhanden | |
|---|---|
| ja | nein |

Prüfung ob FI-Schalter ausgelöst oder $U_B$ zu groß

— — — — — — — — — — —

| Meldung $U_B$ gefährlich |
|---|

Meldung $U_B$ zu groß

— — — — — — — — — — —

| positiver Nulldurchgang<br>S1 ein; S3,S4 aus<br>Start Konstantstrom |
|---|

Integrator aktivieren
Konstantstrom starten
für eine Halbwelle

— — — — — — — — — — —

| negativer Nulldurchgang<br>S3 ein; S1 aus<br>Start Konstantstrom<br>Spannungsmessung $U_{A2}$<br>S4 ein |
|---|

Integrator Hold
Konstantstrom starten
eine Halbwelle
Spannung $U_{A2}$ messen
Integrator neutralisieren

— — — — — — — — — — —

| Differenzbildung<br>$U_{A1} - U_{A2}$ |
|---|

Auswertung der
Sicherheitsabfrage

— — — — — — — — — — —

| Differenz $>$ $U_B$ zul. | |
|---|---|
| ja | nein |

Auswertung
Sicherheitsabfrage

— — — — — — — — — — —

| Durchlaufzähler<br>$\geq$ 100 | |
|---|---|
| ja | nein |

Abfrage ob Meßablauf beendet

— — — — — — — — — — —

| Spannungsmessung |
|---|

Messung der Spannung
L-PE

— — — — — — — — — — —

| Netzspannung vorhanden | |
|---|---|
| ja | nein |

Prüfung ob FI-Schalter ausgelöst hat

— — — — — — — — — — —

| FI-Schalter löst nicht<br>aus |
|---|

Fehlermeldung

— — — — — — — — — — —

| Konstantstrom aus<br>Relais aus |
|---|

Konstantstromschaltung
vom Netz trennen

— — — — — — — — — — —

| Durchlaufzähler<br>+1 |
|---|

Durchlaufzählerstand ist
Maß für Stromgröße

— — — — — — — — — — —

| Konstantstrom $I_k$ um<br>$I_{\Delta N} \cdot 0,01$ erhöhen |
|---|

Konstantstrom erhöhen

k                l   m

Ablaufdiagramm 2B

k                                    l    m

| Stromfluß vorhanden | |
|---|---|
| nein | ja |

Abfrage ob FI-Schalter
ausgelöst

— — — — — — —

Ermittlung von $U_{BF}$
beim Auslösestrom

$$U_B = U_{BN} \cdot \frac{DL-Zähler}{100}$$

Ermittlung der Meßwerte

Ermittlung des Auslösestromes

$$I_A = I_{\Delta N} \cdot \frac{DL-Zähler}{100}$$

— — — — — — —

Konstantstrom aus
Relais aus

Konstantstromschaltung
vom Netz trennen

Ablaufdiagramm **2C**

Fig. 1

EP 0 368 030 B1

Fig. 2

Netz

$I_K$

Integrator $U_E$

Integrator $U_A$

20 ms    20 ms

$U_{BL}$

$U_{BL1}$

$U_{BL2}$

$U_{BL3}$

unbelastet — belastet — unbelastet — belastet

$U_{A1}$    $U_{A2}$

EP 0 368 030 B1

Fig. 3

10ms  10ms

Netz

$I_K$

$I_{K2}$
$I_{K1}$

100%

$I_K'$

$I_{K2} = 100\%$

$I_{K1} = 30\%$

$I_K''$

$U_E$

$U_A$

$U_{A1}$    $U_{A2}$    $U_{A2}$    $U_{A2}$    $U_{A2}$

EP 0 368 030 B1

19

Fig. 4